(19) Europäisches Patentamt / European Patent Office / Office européen des brevets

(11) **EP 4 738 151 A1**

(12) **EUROPEAN PATENT APPLICATION**
published in accordance with Art. 153(4) EPC

(43) Date of publication:
06.05.2026 Bulletin 2026/19

(21) Application number: 24854377.9

(22) Date of filing: 06.08.2024

(51) International Patent Classification (IPC):
*G06F 18/23213* (2023.01)    *G06F 18/26* (2023.01)
*G06F 18/28* (2023.01)    *G06F 18/241* (2023.01)
*G06F 17/15* (2006.01)    *G01R 31/396* (2019.01)

(52) Cooperative Patent Classification (CPC):
G01R 31/396; G06F 17/15; G06F 18/23213;
G06F 18/241; G06F 18/26; G06F 18/28

(86) International application number:
PCT/KR2024/011595

(87) International publication number:
WO 2025/037825 (20.02.2025 Gazette 2025/08)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 14.08.2023 KR 20230106325

(71) Applicant: LG Energy Solution, Ltd.
Seoul 07335 (KR)

(72) Inventors:
• PARK, Hyung Oak
  Daejeon 34122 (KR)
• CHOI, Jee Soon
  Daejeon 34122 (KR)
• PARK, Kyu Tae
  Daejeon 34122 (KR)
• KIM, Ha Yeon
  Daejeon 34122 (KR)

(74) Representative: Plasseraud IP
104 Rue de Richelieu
CS92104
75080 Paris Cedex 02 (FR)

(54) **DATA ANALYSIS DEVICE AND OPERATING METHOD THEREOF**

(57) A data analysis apparatus according to an embodiment disclosed in this document may include an information acquisition unit configured to acquire a plurality of data sets, each containing time-series data for a plurality of parameters, and a controller configured to extract features of each data set based on the correlation between the plurality of parameters, extract patterns of each data set based on the similarity between the extracted features, and classify the plurality of data sets into a plurality of clusters based on the patterns.

FIG.1

Description

## TECHNICAL FIELD

### CROSS REFERENCE TO RELATED APPLICATION

This application claims priority to Korean Patent Application No. 10-2023-0106325, filed August 14, 2023, the entire contents of which is incorporated herein for all purposes by this reference.

### Technical Field

The embodiments disclosed in this document relate to a data analysis apparatus and operating method thereof.

## BACKGROUND ART

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, drawing attention as a next-generation energy storage medium.

Typically, batteries are monitored and controlled by a Battery Management System (BMS). The data collected from the battery management system includes data on a wide variety of factors, and the quantity of data is so vast that it has been difficult to analyze the cause of anomalies even when they occur in the battery.

## DISCLOSURE

## TECHNICAL PROBLEM

It is an object of the embodiments disclosed in this document to provide a data analysis apparatus and operating method thereof capable of effectively identifying the cause of anomalies in a battery by classifying battery data.

The technical objects of the embodiments disclosed in this document are not limited to the aforesaid, and other objects not described herein with be clearly understood by those skilled in the art from the descriptions below.

## TECHNICAL SOLUTION

A data analysis apparatus according to an embodiment disclosed in this document may include an information acquisition unit configured to acquire a plurality of data sets, each containing time-series data for a plurality of parameters, and a controller configured to extract features of each data set based on the correlation between the plurality of parameters, extract patterns of each data set based on the similarity between the extracted features, and classify the plurality of data sets into a plurality of clusters based on the patterns.

According to an embodiment, the controller may extract the features as a matrix representing the correlation between the plurality of parameters.

According to an embodiment, the correlation between the plurality of parameters may be represented by the Pearson correlation coefficient for each parameter pair.

According to an embodiment, the controller may calculate the correlation coefficients between the features of the plurality of data sets and generate a correlation coefficient matrix composed of the correlation coefficients.

According to an embodiment, the controller may apply a classification algorithm to the correlation coefficient matrix to extract the patterns.

According to an embodiment, the classification algorithm may be a K-means algorithm.

According to an embodiment, the controller may extract the patterns based on the results of applying the classification algorithm to the correlation matrix while varying a K value.

According to an embodiment, the controller may analyze the characteristics of each of the plurality of clusters.

According to an embodiment, the controller may analyze the anomaly occurrence history related to the data sets included in each of the plurality of clusters to estimate the parameters associated with the anomaly occurrence history.

According to an embodiment, the controller may extract the features by setting a window interval for each of the plurality of data sets.

According to an embodiment disclosed in this document, an operating method of a data analysis apparatus may include acquiring a plurality of data sets, each containing time-series data for a plurality of parameters, extracting features of each data set based on the correlation between the plurality of parameters, extracting patterns of each data set based on the similarity between the extracted features, and classifying the plurality of data sets into a plurality of clusters based on the patterns.

According to an embodiment, the extracting of the features of each data set may include extracting the features as a matrix representing the correlation between the plurality of parameters.

According to an embodiment, the extracting of the patterns of each data set may include generating a correlation coefficient matrix composed of the correlation coefficients calculated between the features of the plurality of data sets, and applying a classification algorithm to the correlation coefficient matrix to extract the patterns.

According to an embodiment, the classification algorithm may be a K-means algorithm, and the extracting of the patterns by applying the classification algorithm may include extracting the patterns based on the results of applying the classification algorithm while varying a K value to the correlation coefficient matrix.

According to an embodiment, the operating method of the data analysis apparatus may further include estimating the parameters associated with the anomaly occurrence history by analyzing the anomaly occurrence history related to the data sets included in each of the plurality of clusters.

## ADVANTAGEOUS EFFECTS

The data analysis apparatus and operating method thereof according to the embodiments disclosed in this document are advantageous in terms of facilitating the analysis of vast and unstructured data by extracting and classifying patterns from the data set.

The data analysis apparatus and operating method thereof according to the embodiments disclosed in this document are also advantageous in terms of providing a basis for identifying the cause of anomalies by classifying similar data sets.

In addition, various effects identified directly or indirectly through this document can be provided.

## DESCRIPTION OF DRAWINGS

FIG. 1 is a diagram illustrating the configuration of a data analysis system according to an embodiment disclosed in this document;

FIG. 2 is a block diagram illustrating the configuration of a data analysis apparatus according to an embodiment disclosed in this document;

FIG. 3 is a block diagram illustrating the configuration of a controller according to an embodiment disclosed in this document;

FIG. 4 is a diagram illustrating an example of extracted features according to an embodiment disclosed in this document;

FIG. 5 is a diagram illustrating an example of a correlation coefficient matrix according to an embodiment disclosed in this document;

FIG. 6 is a diagram illustrating an example of extracted patterns according to an embodiment disclosed in this document;

FIG. 7 is a flowchart illustrating an operating method of a data analysis apparatus according to an embodiment disclosed in this document;

FIG. 8 is a flowchart explaining the process of extracting patterns according to an embodiment disclosed in this document; and

FIG. 9 is a block diagram illustrating a hardware configuration of a computing system for performing the operating method of a data analysis apparatus according to an embodiment disclosed in this document.

## MODE FOR INVENTION

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

In this document, the singular noun corresponding to an item may encompass one or more instances of that item, unless explicitly indicated otherwise in context. In this document, phrases such as "A or B", "at least one of A and B", "at least one of A or B", "A, B or C", "at least one of A, B, and C", and "at least one of A, B, or C" may each refer to any of the listed items individually or any combination of those items. Terms such as "the first", "the second", "first", "second" are used simply to distinguish one component from another and do not limit these components in other aspects (e.g., importance or order). In this document, when it is mentioned that a component (e.g., the first component) is "coupled" or "connected" to another component (e.g., the second component) with or without terms like "functionally" or "communicatively," it implies that the first component may be connected to the second component directly (e.g., via wired connection), wirelessly, or through a third component.

Each component described in this document (e.g., modules or programs) may include one or more instances. According to various embodiments, one or more components or operations described herein may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

The term "module" or "unit" used in this document may encompass units implemented in hardware, software, or firmware, and may be used interchangeably with terms such as logic, logic block, component, or circuit. A module may be a component assembled as a whole or one or more units performing one or more functions, which may constitute the minimum unit of the component or a part thereof. For example, according to one embodiment, a module may be implemented in the form of an application-specific integrated circuit (ASIC).

Various embodiments of this document may be implemented as software (e.g., a program or application) including one or more instructions stored on a machine-readable storage medium (e.g., memory). For example, the processor of a device may invoke and execute at least one instruction stored on a storage medium. This enables the device to operate to perform at least one function in accordance with the at least one invoked instruction. The one or more instructions may include code generated by a compiler or code executable by an interpreter. The machine-readable storage medium may be provided in the form of a non-transitory storage medium. Here, 'non-transitory' mealy means that the storage medium is a tangible device and does not include signals (e.g., electromagnetic waves), and this term is used regardless of whether the data is stored permanently or temporarily.

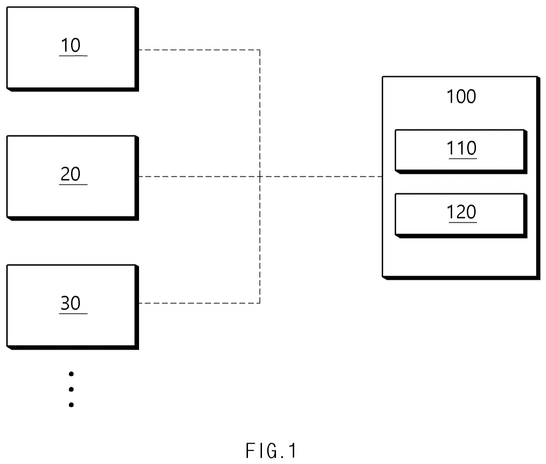

FIG. 1 is a diagram illustrating the configuration of a data analysis system according to an embodiment disclosed in this document.

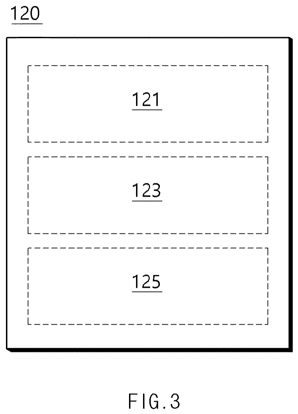

With reference to FIG. 1, the data analysis system may include a battery management system (BMSs) 10, 20 and 30 and a data analysis apparatus 100. Although three battery management systems are depicted in FIG. 3, the number is not limited to three, and the battery management systems 10, 20, and 30 may be configured to include n (where n is a natural number) systems. Each battery management system may be located inside the battery pack or outside the battery pack in configurations where the battery pack is mounted on or connected to a vehicle or charger.

The data analysis apparatus 100 may acquire data sets of time-series data from each of the battery management systems 10, 20, and 30. The data analysis apparatus 100 may classify the acquired multiple data sets into multiple clusters. In more detail, the data analysis apparatus 100 may extract the features of each of the multiple data sets and classify the data sets into multiple clusters by extracting patterns from the extracted features of each data set.

The data analysis apparatus 100 may extract patterns from the data sets acquired in real-time from each battery management system and classify the data sets. In an embodiment, the data analysis apparatus 100 may learn the process of extracting features from the data sets, extracting patterns from the features, and classifying the data sets based on the patterns. The data analysis apparatus 100 may classify new data sets using the trained model when new data sets are acquired.

The data analysis apparatus 100 may also learn the relationship between battery data and battery anomalies by using the classification results of the data sets. For example, the data analysis apparatus 100 may classify data sets and analyze the history of anomalies within the classified clusters to identify the cause of the anomalies.

Through this process, the data analysis apparatus 100 can facilitate the analysis of vast and unstructured data by extracting and classifying patterns from the data sets. Additionally, the data analysis apparatus 100 can classify similar data sets, providing a basis for identifying the cause of anomalies.

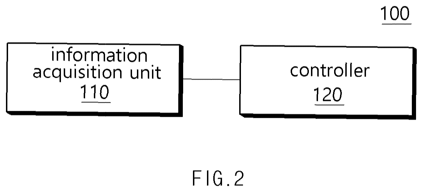

FIG. 2 is a block diagram illustrating the configuration of a data analysis apparatus according to an embodiment disclosed in this document.

With reference to FIG. 2, the data analysis apparatus 100 may include an information acquisition unit 110 and a controller 120.

The information acquisition unit 110 may include a communication circuit capable of establishing wired and/or wireless communication channels between components inside and outside the data analysis apparatus 100, such as servers, vehicles, and battery management systems, and may transmit and receive various types of data through the established communication channels.

The information acquisition unit 110 may acquire a plurality of data sets. Each of the plurality of data sets may include time-series data for a plurality of parameters. In an embodiment, the information acquisition unit 110 may acquire a plurality of data sets from a plurality of battery management systems. For example, the information acquisition unit 110 may acquire each data set from different battery management systems.

The plurality of parameters may include various parameters related to the state of the battery. For example, the plurality of parameters may comprehensively include parameters related to the state of the battery (e.g., current, voltage, temperature), parameters derived from the battery state (e.g., SOC, SOH, DOD, voltage deviation), parameters related to the vehicle when the battery is mounted in a vehicle (e.g., driving time, driving distance, speed, acceleration), and parameters related to external factors that may influence the state of the battery (e.g., ambient temperature), and are not limited to the aforementioned examples.

The controller 120 may extract the features of each of the plurality of data sets based on the correlation between the plurality of parameters. For example, the controller 120 may extract the features of each of the plurality of data sets based on various operations (e.g., covariance, joint probability, etc.) that can calculate the correlation between the plurality of parameters included in the time-series data of each data set.

According to the embodiment, the controller 120 may extract features in the form of a matrix that represents the correlation between the plurality of parameters. For example, the features of each of the plurality of data sets may be expressed as a matrix representing the correlation. For example, when the data sets obtained by the information acquisition unit 110 include time-series data for h (where h is a natural number) parameters, the features extracted by the controller 120 may be represented as an $h*h$ matrix. The correlation between the plurality of parameters may be calculated based on various operations (e.g., covariance, joint probability, etc.) from the data of any two parameters.

According to an embodiment, the correlation between the plurality of parameters may be expressed as the Pearson correlation coefficient for each parameter pair. For example, when the data sets obtained by the information acquisition unit 110 include time-series data for h (where h is a natural number) parameters, the number of parameter pairs may be $h^2$. In this case, the features of each data set are expressed as an h*h matrix, where the value of each component is the Pearson correlation coefficient for the parameter pairs.

In an embodiment, the Pearson correlation coefficient may be defined as shown in Equation 1.

## Equation 1

$$r_{xy} = \frac{\Sigma_{i=1}^{n}(x_i - \overline{x}) * (y_i - \overline{y})}{\sqrt{\Sigma_{i=1}^{n}(x_i - \overline{x})^2}\sqrt{\Sigma_{i=1}^{n}(y_i - \overline{y})^2}}$$

Here, $r_{xy}$ denotes the Pearson correlation coefficient between parameter x and parameter y, n denotes the number of data points included in the time-series data of each parameter, $x_i$ denotes the $i^{th}$ data point in the time-series data of parameter x, $y_i$ denotes the $i^{th}$ data point in the time-series data of parameter y, $\overline{x}$ denotes the mean of parameter x data, and $\overline{y}$ denotes the mean of parameter y data.

That is, the Pearson correlation coefficient may be derived from the covariance and standard deviations of the two parameters. The Pearson correlation coefficient has a normalized value and may range between -1 and 1, for example. As an example, the Pearson correlation coefficient value between identical parameters is 1; accordingly, the values of the elements located on the diagonal of the h*h matrix may be 1.

According to an embodiment, the controller 120 may extract the patterns of each of the plurality of data sets based on the similarity between the extracted features. For example, the controller 120 may cluster each of the plurality of data sets with similar features. The controller 120 may extract the patterns of each data set based on the clustering results.

In another example, the controller 120 may analyze the features of each data set to convert the features of each data set into patterns. As an example, the controller 120 may define a plurality of patterns and determine the pattern of each data set based on the features of that data set. In this case, the controller 120 may learn the process of determining patterns from the features of the data sets.

According to the embodiment, the controller 120 may calculate the correlation coefficients between the features of the plurality of data sets. The controller 120 may derive the correlation coefficients based on various operations (e.g., covariance, joint probability, etc.). For example, the controller 120 may calculate the correlation coefficients between the features based on Equation 2 below.

## Equation 2

$$r = \left(\frac{\Sigma_m \Sigma_n (A_{mn} - \overline{A})(B_{mn} - \overline{B})}{\sqrt{(\Sigma_m \Sigma_n (A_{mn} - \overline{A})^2 (\Sigma_m \Sigma_n (B_{mn} - \overline{B})^2}}\right)$$

Here, A and B each denote the feature matrices, r denotes the correlation coefficient between the features of A and B, $A_{nm}$ denotes the matrix value of the (n,m) element in the feature matrix A, $B_{nm}$ denotes the matrix value of the (n,m) element in the feature matrix B, $\overline{A}$ denotes the mean of the feature matrix A, and $\overline{B}$ denotes the mean of the feature matrix B.

According to the embodiment, the controller 120 may generate a correlation coefficient matrix composed of correlation coefficients. For example, when there are i (where is a natural number) data sets, the correlation coefficient matrix may be an i*i matrix.

According to an embodiment, the controller 120 may apply a classification algorithm to the correlation coefficient matrix to extract the patterns of each of the plurality of data sets. The classification algorithm may include various algorithms such as decision tree-based algorithms like the XGBoost algorithm, K-nearest neighbor classification (K-NN) algorithms like the K-means algorithm, and support vector machine (SVM) algorithms.

According to an embodiment, the classification algorithm may be the K-means algorithm. The K-means algorithm refers to an algorithm that classifies a plurality of data points into K clusters. For example, the K-means algorithm may classify based on the average distance between the centroid of each cluster and the data points.

According to the embodiment, the controller 120 may extract patterns based on the results of applying the classification algorithm to the correlation coefficient matrix while varying the value of K. In the K-means algorithm, the value of K may represent the number of classification clusters. The controller 120 may represent the classified results numerically according to the value of K. For example, when K=2, each data set may belong to either the first cluster or the second cluster. In this case, the controller 120 may assign a classification result value of 0 to the data sets belonging to the first cluster and a value of 1 to the data sets belonging to the second cluster.

In this way, the controller 120 may accumulate classification results while varying the value of K. For example, based on the value of K, the controller 120 may determine the classification result value of each data set to be any value from 0 to K-1. The controller 120 may express the patterns of each data set in the form of a list of classification result values by accumulating the classification results. As an example, the controller 120 may represent the patterns by arranging the classification result values in ascending order based on the value of K.

According to an embodiment, the controller 120 may classify the plurality of data sets into a plurality of clusters based on the patterns. For example, the controller 120 may classify the plurality of data sets into multiple clusters according to the similarity of their patterns. As an example, the controller 120 may classify data sets with identical patterns to belong to the same cluster.

According to an embodiment, the controller 120 may analyze the characteristics of each of the plurality of clusters. For example, the controller 120 may analyze the common characteristics of the data sets belonging to each of the plurality of clusters.

According to an embodiment, the controller 120 may analyze the anomaly occurrence history related to the data sets included in each of the plurality of clusters. The anomaly occurrence history may include various anomalies related to the battery, such as fire occurrence history, voltage anomaly history, and lithium deposition history.

The controller 120 may classify the data sets into a plurality of clusters and analyze the anomaly occurrence history related to the data sets to estimate the causes of the anomalies. For example, when the same anomaly occurrence history exists within the same cluster, it may be inferred that the cause of the anomaly is similar or identical. The anomaly occurrence history related to the data sets may include, for example, the anomalies that occurred in the battery managed by the battery management system from which the data set was obtained.

According to an embodiment, the controller 120 may estimate parameters related to the anomaly occurrence history. The controller 120 may estimate parameters that are determined to be associated with the anomaly occurrence history among a plurality of parameters. The controller 120 may learn the relationship between the patterns of the data sets and the anomaly occurrence history to estimate the parameters.

According to an embodiment, the controller 120 may set a window interval for each of the plurality of data sets to extract features. Here, each of the plurality of data sets may include time-series data, and the time-series data may encompass a plurality of time intervals. The controller 120 may target data corresponding to certain time frames within the time-series data for feature extraction. For example, the controller 120 may set the window interval to cover time intervals with high data reliability, excluding intervals where the time-series data is inaccurate (e.g., initial driving intervals).

FIG. 3 is a block diagram illustrating the configuration of a controller according to an embodiment disclosed in this document.

With reference to FIG. 3, the controller 120 may include a feature extraction module 121 and a classification module 123. The controller 120 may classify each data set into a plurality of clusters using the feature extraction module 121 and the classification module 123. The controller 120 may further include a cause identification module 125.

The feature extraction module 121 may extract features from each of the plurality of data sets. The feature extraction module 121 may also generate a correlation coefficient matrix from the extracted features.

The classification module 123 may extract the patterns of each data set from the extracted features. The classification module 123 may apply a classification algorithm to the features of each data set to extract the patterns. For example, the classification module 123 may include a program that performs the K-means algorithm, changing the K value and performing clustering to extract the patterns of each data set. The classification module 123 may classify the plurality of data sets based on the patterns.

The cause identification module 125 may analyze the anomaly occurrence history based on the classification results of the data sets and the anomalies present in each cluster to determine the causes of the anomalies. For example, the cause identification module 125 may estimate the parameters that are determined to be related to the anomaly occurrence history among the plurality of parameters.

According to an embodiment, the feature extraction module 121, the classification module 123, and the cause identification module 125 may each include a neural network model. The feature extraction module 121 may learn the process of extracting features from each data set. The classification module 123 may learn the process of extracting patterns from the features and classifying the data sets based on the patterns. The cause identification module 125 may learn the process of estimating the causes of anomalies based on the classification results of the data sets and the anomaly occurrence history related to the data sets included in each cluster.

The controller 120 may use the trained feature extraction module 121, classification module 123, and cause identification module 125 to classify the data set even when a new data set is obtained, and to estimate the causes of anomalies when an anomaly occurs in the battery related to the data set.

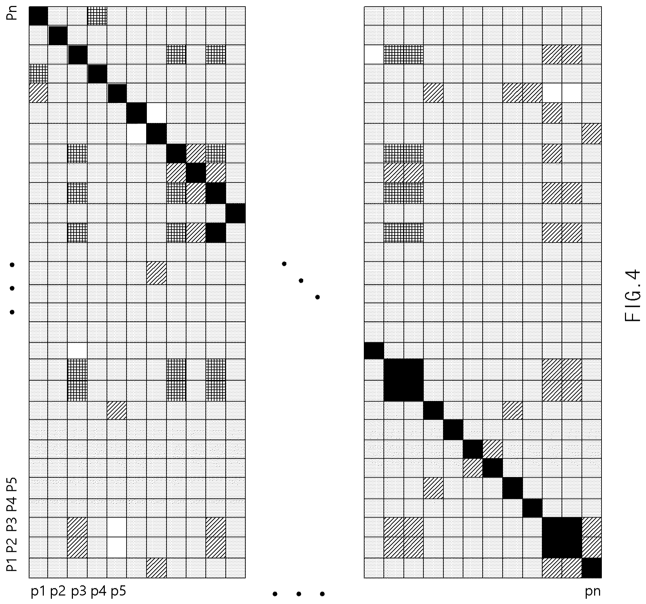

FIG. 4 is a diagram illustrating an example of extracted features according to an embodiment disclosed in this document.

With reference to FIG. 4, the controller 120 may extract the features of each data set. Each feature may be represented as a matrix that indicates the correlation between a plurality of parameters. For example, the value of each element in the feature matrix may be the Pearson correlation coefficient for each pair of parameters.

In FIG. 4, each row and each column represent the parameters (f1 to fn), and the elements of the matrix may be expressed as the Pearson correlation coefficients between the parameters corresponding to the row and column in which the element is located. In an embodiment, the elements in the feature matrix may be represented by numerical values or differentiated by colors, as shown in FIG. 4.

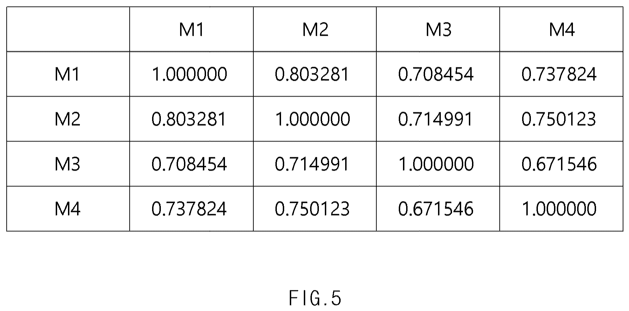

FIG. 5 is a diagram illustrating an example of a correlation coefficient matrix according to an embodiment disclosed in this document.

With reference to FIG. 5, the controller 120 may generate a correlation coefficient matrix from the features of each data set. In FIG. 5, M1 to M4 represent the feature matrices of each data set, and each element signifies the correlation coefficient between the features. The quantity and values shown in FIG. 5 are for illustrative purposes only and are not limited to these examples. As shown in FIG. 5, the correlation coefficients of each data set may be normalized values between -1 and 1.

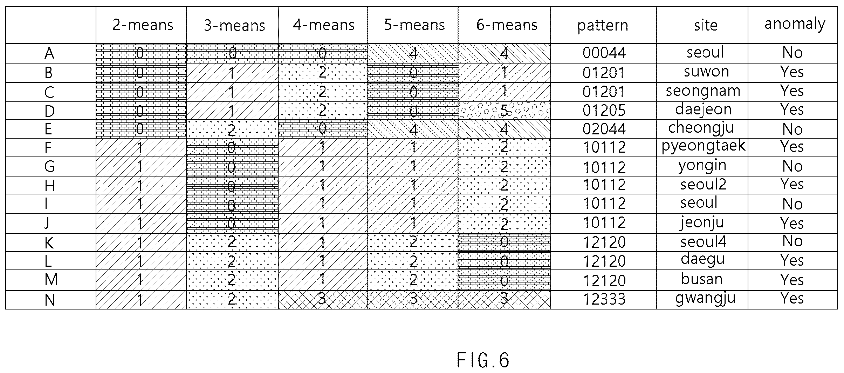

FIG. 6 is a diagram illustrating an example of extracted patterns according to an embodiment disclosed in this document.

With reference to FIG. 6 ,the controller 120 may extract the patterns of each data set. A to N represent the data sets, and the patterns of each data set are shown in the sixth column of the matrix shown in FIG. 6.

In this embodiment, the controller 120 may change the K value to classify the data sets and accumulate the classification results. For example, the controller 120 may determine the classification results as one of the values from 0 to K-1 based on the K value. In FIG. 6, the first to fifth columns represent the classification results obtained by setting the K value from 2 to 6, respectively. The controller 120 may generate patterns by listing the classification result values for each data set. For example, the pattern of data set A may be defined as 00044, while the pattern of data set H may be defined as 10112.

Based on the patterns, the controller 120 may classify a plurality of data sets. For example, since data sets F to J share the same pattern of 10112, the controller 120 may classify them into the same cluster.

The controller 120 may analyze the anomaly occurrence history related to the data sets included in each cluster to estimate the parameters associated with the anomaly occurrence history. In FIG. 6, the eighth column indicates whether anomalies have occurred in each data set. The controller 120 may estimate the parameters associated with the anomaly occurrence history by comprehensively analyzing the anomaly history from the data sets and the classifications to which the data sets belong. For example, among the data sets F to J that share the same pattern of 10112, the controller 120 may infer that the anomalies occurring in the data sets F, H, and J have the same or similar causes.

While the anomaly occurrence history in FIG. 6 is represented simply as the occurrence of anomalies, the data management apparatus 100 may include various information related to the anomalies, such as the number of occurrences, types of anomalies, and times of occurrence, within the anomaly occurrence history.

The controller 120 may also manage and store the locations where each data set was obtained or the position of the BMS, as indicated in the seventh column of FIG. 6.

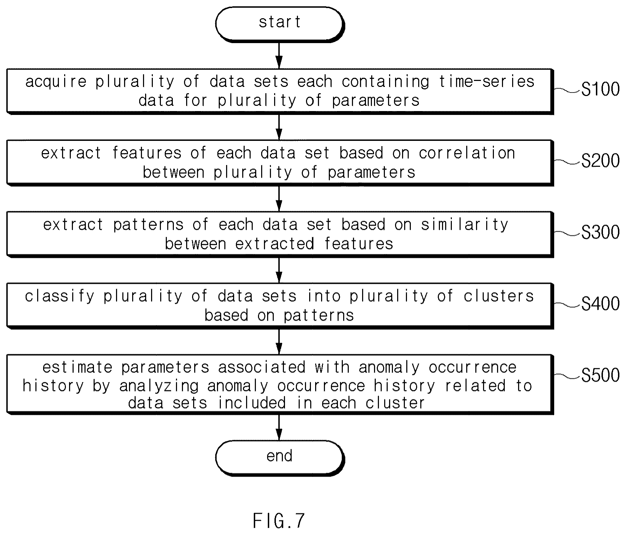

FIG. 7 is a flowchart illustrating an operating method of a data analysis apparatus according to an embodiment disclosed in this document. The embodiment shown in FIG. 7 is merely illustrative, and the order of operations according to various embodiments of the present invention may be different from that shown in FIG. 7, and some operations shown in FIG. 7 may be omitted, changed in order, or merged.

With reference to FIG. 7, the operating method of the data analysis apparatus may include acquiring a plurality of data sets, each containing time-series data for a plurality of parameters, in operation S100, extracting the features of each data set based on the correlation between the plurality of parameters in operation S200, extracting the patterns of each data set based on the similarity between the extracted features in operation S300, classifying the plurality of data sets into a plurality of clusters based on the patterns in operation S400, and estimating the parameters associated with the anomaly occurrence history in operation S500 by analyzing the anomaly occurrence history related to the data sets included in each cluster.

In operation S100, the information acquisition unit 110 may acquire a plurality of data sets. The information acquisition unit 110 may acquire time-series data from each of the plurality of battery management systems as data sets.

In operation S200, the controller 120 may extract the features of each data set based on the correlation between the plurality of parameters. For example, the controller 120 may represent the features as a matrix indicating the Pearson correlation coefficients for the plurality of parameters.

In operation S300, the controller 120 may extract the patterns of each data set based on the similarity between the extracted features. For example, the controller 120 may generate a correlation coefficient matrix from the features and apply a classification algorithm to the correlation coefficient matrix to extract the patterns of each data set.

In operation S400, the controller 120 may classify the plurality of data sets based on the patterns. For example, the controller 120 may classify data sets with the same pattern into the same cluster.

In operation S500, the controller 120 may analyze the anomaly occurrence history related to the data sets included in each cluster to estimate the parameters associated with the anomaly occurrence history.

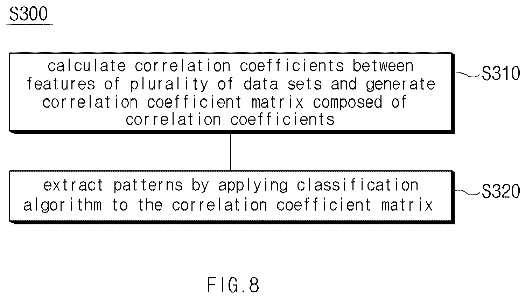

FIG. 8 is a flowchart explaining the process of extracting patterns according to an embodiment disclosed in this document.

With reference to FIG. 8, the controller 120 may calculate the correlation coefficient matrix from the plurality of data sets and extract patterns from the correlation coefficient matrix.

In operation S310, the controller 120 may calculate the correlation coefficients between the features of the plurality of data sets to generate a correlation coefficient matrix composed of the correlation coefficients.

In operation S320, the controller 120 may apply a classification algorithm to the correlation coefficient matrix to extract patterns. The classification algorithm may include, for example, the K-means algorithm. The controller 120 may apply the K-means algorithm while varying the K value on the correlation coefficient matrices and accumulate the classification results. The controller 120 may extract the patterns of each data set from the accumulated classification results.

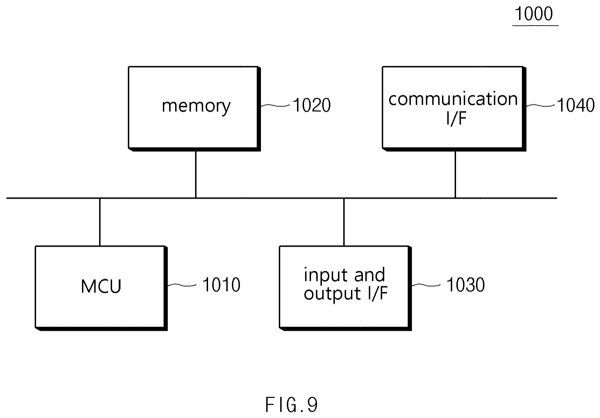

FIG. 9 is a block diagram illustrating a hardware configuration of a computing system for performing the operating method of a data analysis apparatus according to an embodiment disclosed in this document.

With reference to FIG. 9, the computing system 1000 according to an embodiment disclosed in this document may include an MCU 1010, a memory 1020, an input/output interface (I/F) 1030, and a communication interface (I/F) 1040.

The MCU 1010 may be a processor that executes various programs (e.g., battery data acquisition programs, feature extraction programs, correlation matrix generation programs, pattern extraction programs, classification programs, etc.) stored in the memory 1020 and processes various information, including time-series data of the data set, through these programs to perform the functions of the controller included in the data analysis apparatus described with reference to FIG. 2.

The memory 1020 may store various programs such as battery data acquisition programs, feature extraction programs, correlation matrix generation programs, pattern extraction programs, and classification programs. The memory 1020 may also store various information including classification results of the data sets and anomaly occurrence history.

The 1020 may be provided in plurality, as necessary. The memory 1020 may be a volatile memory or a non-volatile memory. The memory 1020 as a volatile memory may be RAM, DRAM, SRAM, or the like. The memory 1020 as a non-volatile memory may be ROM, PROM, EAROM, EPROM, EEPROM, flash memory, or the like. The memory 1020 is not limited to listed examples and are not limited to these examples.

The input and output I/F 1030 is an interface that connects an input device (not shown) such as a keyboard, mouse, or touch panel, an output device such as a display (not shown), and the MCU 1010 to transmit and receive data.

The communication I/F 1040 may be a component capable of communicating various data with a server, encompassing various devices supporting wired or wireless communication. For example, the data analysis apparatus may transmit and receive various information including anomaly occurrence history in the data sets to and from a separate external server via the communication I/F 1040.

In this way, a computer program according to an embodiment disclosed in this document may be recorded in the memory 1020 and processed by the MCU 1010 to be implemented as modules performing the functions described with reference to FIG. 2.

Although all components are described as being combined or operating as one, the embodiments disclosed in this document are not limited to these examples. That is, within the scope of the embodiments disclosed in this document, all of the components may also be selectively combined in one or more ways to function.

Furthermore, terms such as "comprise," "include," or "have" as used above should be interpreted to imply the inclusion of the specified components unless specifically stated otherwise, rather than excluding other components, and may include additional components. Unless otherwise defined, all terms, including technical or scientific terms used herein, have the same meanings as commonly understood by those skilled in the art to which the embodiments disclosed in this invention belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The above description is only an illustrative example of the technical idea disclosed in this document, and those skilled in the art to which the embodiments disclosed in this document belong will be able to make various modification and changes without departing from the subject matter of the embodiments disclosed in this document. Therefore, the embodiments disclosed in this document are not intended to limit the technical concept disclosed in this document but are for the purpose of illustration, and the scope of the technical concept disclosed in this document is not limited by these embodiments. The scope of protection for the technical concepts disclosed in this document should be interpreted in accordance with the claims set forth below, and all equivalent technical concepts should be considered as included in the scope of protection of this document.

DESCRIPTION OF REFERENCE NUMERALS

    10, 20, 30: battery management system
    100: data analysis apparatus
    110: information acquisition unit
    120: controller
    121: feature extraction module
    123: classification module
    125: cause identification module
    1000: computing system
    1010: MCU

1020: memory
1030: input/output I/F
1040: communication I/F

**Claims**

1. A data analysis apparatus comprising:

   an information acquisition unit configured to acquire a plurality of data sets, each containing time-series data for a plurality of parameters; and
   a controller configured to extract features of each data set based on the correlation between the plurality of parameters, extract patterns of each data set based on the similarity between the extracted features, and classify the plurality of data sets into a plurality of clusters based on the patterns.

2. The data analysis apparatus of claim 1, wherein the controller extracts the features as a matrix representing the correlation between the plurality of parameters.

3. The data analysis apparatus of claim 2, wherein the correlation between the plurality of parameters is represented by the Pearson correlation coefficient for each parameter pair.

4. The data analysis apparatus of claim 1, wherein the controller calculates the correlation coefficients between the features of the plurality of data sets and generates a correlation coefficient matrix composed of the correlation coefficients.

5. The data analysis apparatus of claim 4, wherein the controller applies a classification algorithm to the correlation coefficient matrix to extract the patterns.

6. The data analysis apparatus of claim 5, wherein the classification algorithm is a K-means algorithm.

7. The data analysis apparatus of claim 6, wherein the controller extracts the patterns based on the results of applying the classification algorithm to the correlation coefficient matrix while varying a K value.

8. The data analysis apparatus of claim 1, wherein the controller analyzes the characteristics of each of the plurality of clusters.

9. The data analysis apparatus of claim 8, wherein the controller analyzes the anomaly occurrence history related to the data sets included in each of the plurality of clusters to estimate the parameters associated with the anomaly occurrence history.

10. The data analysis apparatus of claim 1, wherein the controller extracts the features by setting a window interval for each of the plurality of data sets.

11. An operating method of a data analysis apparatus, the method comprising:

    acquiring a plurality of data sets, each containing time-series data for a plurality of parameters;
    extracting features of each data set based on the correlation between the plurality of parameters;
    extracting patterns of each data set based on the similarity between the extracted features; and
    classifying the plurality of data sets into a plurality of clusters based on the patterns.

12. The method of claim 11, wherein the extracting of the features of each data set comprises extracting the features as a matrix representing the correlation between the plurality of parameters.

13. The method of claim 11, wherein the extracting of the patterns of each data set comprises:

    generating a correlation coefficient matrix composed of the correlation coefficients calculated between the features of the plurality of data sets; and
    applying a classification algorithm to the correlation coefficient matrix to extract the patterns.

14. The method of claim 13, wherein the classification algorithm is a K-means algorithm, and the extracting of the patterns by applying the classification algorithm comprises extracting the patterns based on the results of applying the classification algorithm while varying a K value to the correlation coefficient matrix.

15. The method of claim 11, further comprising estimating the parameters associated with the anomaly occurrence history by analyzing the anomaly occurrence history related to the data sets included in each of the plurality of clusters.

10

20

30

100

110

120

FIG.1

100

| information acquisition unit 110 | controller 120 |

FIG.2

120

121

123

125

FIG.3

FIG. 4

|      | M1       | M2       | M3       | M4       |
| :--: | :------: | :------: | :------: | :------: |
| M1   | 1.000000 | 0.803281 | 0.708454 | 0.737824 |
| M2   | 0.803281 | 1.000000 | 0.714991 | 0.750123 |
| M3   | 0.708454 | 0.714991 | 1.000000 | 0.671546 |
| M4   | 0.737824 | 0.750123 | 0.671546 | 1.000000 |

FIG.5

| | 2-means | 3-means | 4-means | 5-means | 6-means | pattern | site | anomaly |
|---|---|---|---|---|---|---|---|---|
| A | 0 | 0 | 0 | 4 | 4 | 00044 | seoul | No |
| B | 0 | 1 | 2 | 0 | 1 | 01201 | suwon | Yes |
| C | 0 | 1 | 2 | 0 | 1 | 01201 | seongnam | Yes |
| D | 0 | 1 | 2 | 0 | 5 | 01205 | daejeon | Yes |
| E | 0 | 2 | 0 | 4 | 4 | 02044 | cheongju | No |
| F | 1 | 0 | 1 | 1 | 2 | 10112 | pyeongtaek | Yes |
| G | 1 | 0 | 1 | 1 | 2 | 10112 | yongin | No |
| H | 1 | 0 | 1 | 1 | 2 | 10112 | seoul2 | Yes |
| I | 1 | 0 | 1 | 1 | 2 | 10112 | seoul | No |
| J | 1 | 0 | 1 | 1 | 2 | 10112 | jeonju | Yes |
| K | 1 | 2 | 1 | 2 | 0 | 12120 | seoul4 | No |
| L | 1 | 2 | 1 | 2 | 0 | 12120 | daegu | Yes |
| M | 1 | 2 | 1 | 2 | 0 | 12120 | busan | Yes |
| N | 1 | 2 | 3 | 3 | 3 | 12333 | gwangju | Yes |

FIG.6

start

acquire plurality of data sets each containing time-series data for plurality of parameters ～S100

extract features of each data set based on correlation between plurality of parameters ～S200

extract patterns of each data set based on similarity between extracted features ～S300

classify plurality of data sets into plurality of clusters based on patterns ～S400

estimate parameters associated with anomaly occurrence history by analyzing anomaly occurrence history related to data sets included in each cluster ～S500

end

FIG.7

S300

| calculate correlation coefficients between features of plurality of data sets and generate correlation coefficient matrix composed of correlation coefficients |
| --- |

~S310

| extract patterns by applying classification algorithm to the correlation coefficient matrix |
| --- |

~S320

FIG.8

1000

memory —1020

communication I/F —1040

MCU —1010

input and output I/F —1030

FIG.9

## INTERNATIONAL SEARCH REPORT

| International application No. |
|---|
| **PCT/KR2024/011595** |

| A. | CLASSIFICATION OF SUBJECT MATTER |
|---|---|

**G06F 18/23213**(2023.01)i; **G06F 18/26**(2023.01)i; **G06F 18/28**(2023.01)i; **G06F 18/241**(2023.01)i; **G06F 17/15**(2006.01)i; **G01R 31/396**(2019.01)i

According to International Patent Classification (IPC) or to both national classification and IPC

| B. | FIELDS SEARCHED |
|---|---|

Minimum documentation searched (classification system followed by classification symbols)

G06F 18/23213(2023.01); F24F 11/38(2018.01); G06F 17/00(2006.01); G06F 17/27(2006.01); G06N 3/08(2006.01); H04L 9/40(2022.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 파라미터(parameter), 상관 관계(correlation), 패턴(pattern), 군집(cluster)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2023-0016575 A (SAMSUNG ELECTRONICS CO., LTD.) 02 February 2023 (2023-02-02)<br>See paragraphs [0038]-[0050], claim 1 and figure 2. | 1-15 |
| Y | KR 10-2009-0069874 A (KOREA INSTITUTE OF SCIENCE & TECHNOLOGY INFORMATION) 01 July 2009 (2009-07-01)<br>See claims 1, 5 and 7 and figures 2-5. | 1-15 |
| A | KR 10-2022-0049674 A (ELECTRONICS AND TELECOMMUNICATIONS RESEARCH INSTITUTE) 22 April 2022 (2022-04-22)<br>See claims 1-3 and figures 1-4. | 1-15 |
| A | KR 10-2021-0078256 A (LG ELECTRONICS INC.) 28 June 2021 (2021-06-28)<br>See claims 1-4 and figures 1-6. | 1-15 |
| A | KR 10-2023-0020998 A (KLA CORPORATION) 13 February 2023 (2023-02-13)<br>See claims 1, 4 and 10 and figures 3-4. | 1-15 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 November 2024** | **05 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/011595**

| Patent document cited in search report | | | Publication date (day/month/year) | Patent family member(s) | | | Publication date (day/month/year) |
|---|---|---|---|---|---|---|---|
| KR | 10-2023-0016575 | A | 02 February 2023 | CN | 115688665 | A | 03 February 2023 |
| | | | | TW | 202305607 | A | 01 February 2023 |
| | | | | US | 11791184 | B2 | 17 October 2023 |
| | | | | US | 2023-0023762 | A1 | 26 January 2023 |
| KR | 10-2009-0069874 | A | 01 July 2009 | None | | | |
| KR | 10-2022-0049674 | A | 22 April 2022 | KR | 10-2420994 | B1 | 18 July 2022 |
| KR | 10-2021-0078256 | A | 28 June 2021 | None | | | |
| KR | 10-2023-0020998 | A | 13 February 2023 | CN | 115699279 | A | 03 February 2023 |
| | | | | CN | 115699279 | B | 15 December 2023 |
| | | | | KR | 10-2713705 | B1 | 04 October 2024 |
| | | | | TW | 202212802 | A | 01 April 2022 |
| | | | | US | 11328435 | B2 | 10 May 2022 |
| | | | | US | 2021-0383557 | A1 | 09 December 2021 |
| | | | | WO | 2021-252246 | A1 | 16 December 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230106325